# DEMANDE DE BREVET EUROPEEN

(11) **EP 2 244 532 A1**
(43) Date de publication de la demande: **27.10.2010**
(21) Numéro de dépôt: 10159972.8
(22) Date de dépôt: 15.04.2010
(51) Int. Cl.: H05B 33/08

(54) **Dispositif et procédé de gestion du fonctionnement d'organe(s) électrique(s) remplacé(s) dans un système**

(30) Priorité: 21.04.2009 FR 0952589
(71) Demandeur: Peugeot Citroën Automobiles SA, 78140 Vélizy-Villacoublay (FR)
(72) Inventeur: Lefranc, Francis, 78390 BOIS D'ARCY (FR)
(74) Mandataire: Vigand, Régis Louis Michel

(57) **Abrégé**

Un dispositif (D) est dédié à la gestion du fonctionnement d'organes électriques (L) faisant partie d'un système, interchangeables, produisant un résultat variable en fonction de la valeur d'au moins une grandeur électrique qui leur est appliquée, et appartenant à au moins une famille subdivisée en au moins deux types différents correspondant à des résultats standards propres. Ce dispositif (D) se caractérise par le fait qu'il comprend i) des moyens de stockage (MS) stockant une table établissant une correspondance entre des types d'organes électriques de famille(s) et des résultats standards propres, ii) des moyens de comparaison (MC) chargés de générer une alarme lorsque des états de fonctionnement en cours et mémorisé d'un organe électrique (L) diffèrent, iii) des moyens d'interface homme/machine (MI) permettant à une personne de fournir le type d'un organe électrique (L) d'une famille, et iv) des moyens de gestion (MG) chargés, en cas de génération d'une alarme relative à un organe électrique (L) d'une famille, de requérir la fourniture du type de cet organe électrique (L), puis de déterminer la valeur de chaque grandeur électrique qui doit être appliquée à cet organe électrique (L) pour qu'il produise un résultat choisi compte tenu du résultat standard qui correspond à son type fourni au sein de la table.

## Description

L'invention concerne les systèmes qui sont équipés d'organes électriques interchangeables, et plus précisément la gestion du fonctionnement de tels organes électriques.

Certains systèmes, comme par exemple des véhicules (notamment automobiles), sont équipés d'organes électriques interchangeables qui produisent un résultat variable en fonction de la valeur d'au moins une grandeur électrique (tension, courant ou courant à modulation de largeur d'impulsion (ou PWM (pour « Pulse Width Modulation »)). Un tel organe électrique peut par exemple, et non limitativement, être une lampe, une ampoule ou une diode qui produit un résultat de type flux lumineux (pour un éclairage d'ambiance ou de signalisation).

Les systèmes précités sont généralement conçus pour utiliser des organes électriques de type standard, et donc pour toujours appliquer à ces derniers une même valeur de grandeur électrique de manière à toujours obtenir un même résultat. Dans ce cas, il n'y a pas lieu de se préoccuper des conséquences en terme de consommation électrique du remplacement d'un organe électrique de type standard.

Cependant, pour remplir certaines fonctions, il est aujourd'hui possible d'utiliser des organes électriques qui appartiennent à des familles différentes et éventuellement subdivisées en au moins deux types différents qui correspondent à des résultats standards propres. Ainsi, dans le domaine automobile, certaines fonctions d'éclairage peuvent être réalisées avec des lampes halogènes qui appartiennent à plusieurs familles, par exemple appelées H1, H3 et H7, et chaque famille est subdivisée en au moins trois types (standard, économique et haut rendement). On comprendra qu'une lampe à haut rendement produira un flux lumineux (ou résultat standard propre) plus important qu'une lampe standard pour une même valeur de grandeur physique appliquée. De même, une lampe standard produira un flux lumineux plus important qu'une lampe économique pour une même valeur de grandeur physique appliquée. Par conséquent, lorsque l'on remplace dans un système un organe électrique d'un certain type par un organe électrique d'un autre type, et éventuellement d'une famille différente, il est probable que le résultat produit par le nouvel organe électrique diffère de celui précédemment offert par celui qui a été remplacé étant donné que la valeur de grandeur physique qui lui est appliquée est identique à celle qui était appliquée à l'organe électrique remplacé.

Cette situation n'est pas optimale et peut parfois s'avérer dangereuse lorsque le résultat produit par un nouvel organe électrique ne satisfait plus à des normes nationales ou internationales.

L'invention a donc pour but de remédier à l'inconvénient précité.

Elle propose à cet effet un dispositif, dédié à la gestion du fonctionnement d'organe(s) électrique(s) faisant partie d'un système, interchangeable(s), produisant un résultat variable en fonction de la valeur d'au moins une grandeur électrique qui lui (leur) est appliquée, et appartenant à au moins une famille qui est subdivisée en au moins deux types différents qui correspondent à des résultats standards propres.

Ce dispositif de gestion se caractérise par le fait qu'il comprend :
- des moyens de stockage propres à stocker une table qui établit une correspondance entre des types d'organes électriques de famille(s) et des résultats standards propres,
- des moyens de comparaison agencés de manière à générer une alarme lorsque des états de fonctionnement en cours et mémorisé d'un organe électrique diffèrent,
- des moyens d'interface homme/machine agencés pour permettre à une personne de fournir le type d'un organe électrique d'une famille, et
- des moyens de gestion agencés, en cas de génération d'une alarme relative à un organe électrique d'une famille, pour requérir la fourniture du type de cet organe électrique, puis pour déterminer la valeur de chaque grandeur électrique qui doit être appliquée à cet organe électrique pour qu'il produise un résultat choisi, compte tenu du résultat standard qui correspond à son type fourni au sein de la table.

En complément, les moyens de gestion peuvent être également agencés, lorsqu'une personne fournit spontanément, via les moyens d'interface homme/machine, le type d'un organe électrique d'une famille qui vient d'être remplacé dans le système, pour déterminer la valeur de chaque grandeur électrique qui doit être appliquée à cet organe électrique pour qu'il produise un résultat choisi, compte tenu du résultat standard qui correspond à son type fourni au sein de la table.

L'invention propose également un procédé dédié à la gestion du fonctionnement d'organe(s) électrique(s) faisant partie d'un système, interchangeable(s), produisant un résultat variable en fonction de la valeur d'au moins une grandeur électrique qui lui (leur) est appliquée, et appartenant à au moins une famille qui est subdivisée en au moins deux types différents qui correspondent à des résultats standards propres.

Ce procédé de gestion se caractérise par le fait qu'il consiste à effectuer les étapes suivantes lors de chaque démarrage du système :
i) comparer l'état de fonctionnement en cours d'un organe électrique à un état de fonctionnement mémorisé de cet organe électrique, afin de générer une alarme lorsque ces états de fonctionnement diffèrent,
ii) en cas de génération d'une alarme relative à un organe électrique d'une famille, requérir la fourniture du type de cet organe électrique, et
iii) déterminer la valeur de chaque grandeur électrique qui doit être appliquée à cet organe électrique pour qu'il produise un résultat choisi, compte tenu du résultat standard qui correspond à son type fourni au sein d'une table qui établit une correspondance entre des types d'organes électriques de famille(s) et des résultats standards propres.

En complément, en cas de fourniture spontanée du type d'un organe électrique d'une famille qui vient d'être remplacé dans le système, on peut déterminer la valeur de chaque grandeur électrique qui doit être appliquée à cet organe électrique pour qu'il produise un résultat choisi, compte tenu du résultat standard qui correspond à son type fourni au sein de la table de correspondance.

L'invention est bien adaptée, bien que non limitativement, aux organes électriques qui sont choisis parmi (au moins) des lampes, des ampoules et des diodes propres à produire un résultat de type flux lumineux.

Par ailleurs, l'invention est également bien adaptée, bien que non limitativement, aux systèmes tels que des véhicules (éventuellement automobiles).

D'autres caractéristiques et avantages de l'invention apparaîtront à l'examen de la description détaillée ci-après, et des dessins annexés, sur lesquels :
- la figure 1 illustre schématiquement et fonctionnellement un système équipé de deux organes électriques et d'un exemple de réalisation de dispositif de gestion selon l'invention, et
- la figure 2 est un diagramme illustrant un exemple d'enchaînement d'étapes d'un procédé de gestion selon l'invention.

Les dessins annexés pourront non seulement servir à compléter l'invention, mais aussi contribuer à sa définition, le cas échéant.

L'invention a pour but d'offrir un procédé de gestion et un dispositif de gestion (D) permettant de gérer le fonctionnement d'organe(s) électrique(s) interchangeable(s) (L), faisant partie d'un système (V).

Dans ce qui suit, on considère, à titre d'exemple non limitatif, que le système (V) est un véhicule automobile, comme par exemple une voiture. Mais, l'invention n'est pas limitée à ce type de système. Elle concerne en effet tout type de système comprenant au moins un organe électrique interchangeable.

Par ailleurs, on considère dans ce qui suit, à titre d'exemple non limitatif, que les organes électriques interchangeables sont des lampes, par exemple dédiées à l'éclairage de signalisation d'une voiture. Mais, l'invention n'est pas limitée à ce type d'organe électrique interchangeable (L). Elle concerne en effet tout type d'organe électrique interchangeable, produisant un résultat qui varie en fonction de la valeur d'au moins une grandeur électrique qui lui est appliquée, et qui appartient à au moins une famille qui est subdivisée en au moins deux types différents qui correspondent à des résultats standards propres. Par conséquent, elle concerne également et notamment les ampoules et les diodes.

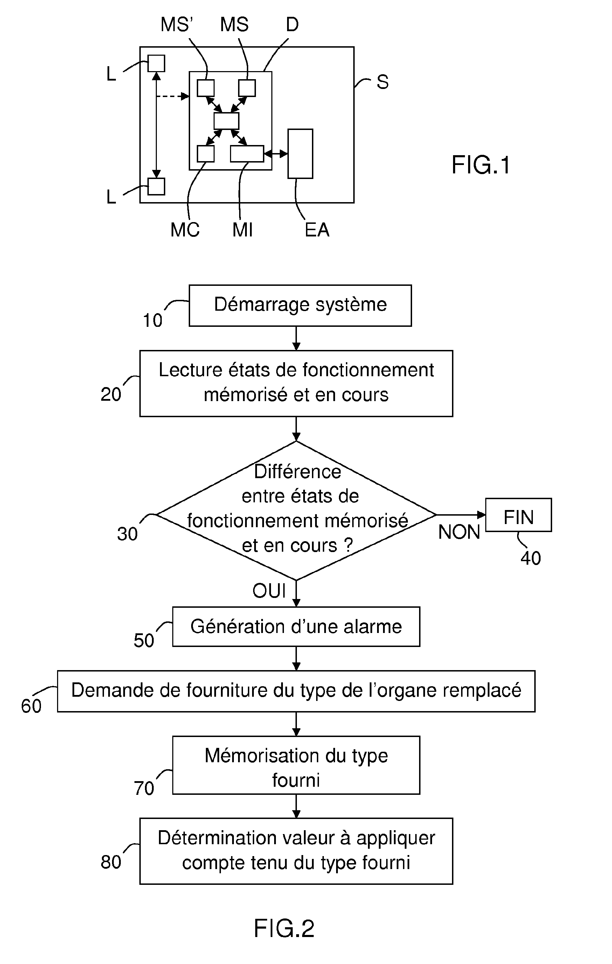

On a schématiquement représenté sur la figure 1 un système V (ici une voiture) équipé de deux organes électriques L (ici des lampes halogènes), par exemple et non limitativement identiques, et d'un exemple de réalisation d'un dispositif de gestion D selon l'invention.

Comme illustré, un tel dispositif de gestion D comprend au moins des moyens de stockage MS, des moyens de comparaison MC, des moyens d'interface homme/machine MI et des moyens de gestion MG qui coopèrent ensemble.

Les moyens de stockage MS sont agencés de manière à stocker une table (informatique) qui établit une correspondance entre des types d'organes électriques L (ici des lampes (halogènes)) faisant partie d'au moins une famille et des résultats standards propres.

On entend ici par « résultat standard propre » le résultat qui est produit par un organe électrique L lorsqu'on lui applique une valeur standard prédéfinie d'au moins une grandeur électrique, comme par exemple une tension, un courant ou un courant à modulation de largeur d'impulsion (ou PWM (pour Pulse Width Modulation)), pour le faire fonctionner au sein d'un système V. Lorsque l'organe électrique L est une lampe, le résultat qu'il produit est un flux lumineux, et le nombre standard de lux qu'émet cet organe électrique en condition standard de fonctionnement est défini par le fabricant. Si l'on fait fonctionner cet organe électrique L dans des conditions de fonctionnement supérieures, respectivement inférieures, aux conditions standards, le nombre de lux qu'il va émettre sera supérieur, respectivement inférieur, au nombre standard.

Par exemple, les lampes halogènes L (ici considérées) appartiennent à trois familles appelées H1, H3 et H7, et chaque famille est subdivisée en au moins trois types (standard, économique et haut rendement). Dans ce cas la table de correspondance mémorisée dans les moyens de stockage MS comprend au moins neuf entrées de type (au moins trois types pour chacune des trois familles). On notera que le type peut également porter sur la couleur de la lumière émise.

Les moyens de stockage MS peuvent se présenter sous n'importe quelle forme connue de l'homme de l'art, et notamment sous la forme d'une mémoire, éventuellement purement logicielle, ou une base de données, éventuellement purement logicielle, par exemple lorsque de nombreux organes électriques appartenant à de nombreuses familles doivent être gérés par le dispositif D.

Les moyens de comparaison MC sont agencés de manière à générer une alarme lorsque l'état de fonctionnement en cours d'une lampe L diffère de l'état de fonctionnement mémorisé de cette même lampe L.

Pour ce faire, les moyens de comparaison MC peuvent par exemple aller lire (ou requérir) l'état de fonctionnement en cours d'une lampe L et l'état de fonctionnement préalablement mémorisé de cette lampe L.

L'état de fonctionnement préalablement mémorisé est l'état de fonctionnement dans lequel était la lampe L lors du fonctionnement précédent de la voiture V et donc du dispositif D.

L'état de fonctionnement en cours est l'état de fonctionnement dans lequel se trouve la lampe L à l'instant où le dispositif D est utilisé et donc consécutivement au démarrage de la voiture V.

On comprendra qu'une lampe L est soit en bon état de fonctionnement soit hors de fonctionnement, par conséquent un unique bit de données permet de définir deux valeurs (0 et 1) correspondant respectivement aux deux états de fonctionnement précités. L'état de fonctionnement préalablement mémorisé peut donc être stocké dans une mémoire MS', qui peut éventuellement faire partie du dispositif D (comme illustré non limitativement) ou bien d'un calculateur embarqué ou de l'ordinateur de bord de la voiture V. L'état de fonctionnement en cours est accessible auprès d'un équipement embarqué dans la voiture V et couplé aux lampes L, comme par exemple les moyens de contrôle d'alimentation (ou de pilotage) des organes comportant les lampes L ou le boîtier « d'intelligence » de la voiture V.

Une fois que les moyens de comparaison MC disposent des deux états de fonctionnement en cours et mémorisé d'une lampe L, ils peuvent par exemple procéder à leur comparaison afin de déterminer si ils diffèrent l'un de l'autre.

Si il n'existe pas de différence entre ces deux états lus, alors les moyens de comparaison MC ne génèrent pas d'alarme. En effet, soit la lampe L était précédemment en bon état de fonctionnement et est toujours en bon état de fonctionnement, et donc il n'y a pas lieu d'intervenir, soit la lampe L était précédemment hors de fonctionnement et est toujours hors de fonctionnement, et donc il n'y a pas lieu d'intervenir (on suppose ici qu'un message d'avertissement est automatiquement affiché sur l'écran d'affichage EA de la voiture V lorsqu'une lampe L ne fonctionne pas - dans le cas contraire on pourrait envisager que ce soit le dispositif D qui provoque l'affichage d'un tel message d'avertissement consécutivement à la comparaison des deux états de fonctionnement).

En revanche, si il existe une différence entre les deux états lus, alors les moyens de comparaison MC génèrent une alarme. On entend ici par « alarme » tout signal analogique ou tout message numérique prédéfini destiné à signaler une différence entre les deux états de fonctionnement lus. Lorsque le dispositif D ne gère qu'une seule famille de lampes L, le message d'alarme peut par exemple être une valeur de tension ou de courant prédéfinie ou bien une valeur choisie, par exemple égale à 1, d'un bit de donnée. En revanche, dès lors que le dispositif D gère plusieurs familles de lampes L, le message d'alarme doit également signaler la famille à laquelle appartient la lampe L objet de la comparaison. Par conséquent, il faut prévoir un message d'alarme dédié pour chaque famille. Par exemple, on prévoit pour chaque famille une valeur de tension ou de courant dédiée ou bien un jeu d'au moins deux bits de données de valeurs choisies.

On notera qu'il n'est véritablement utile de générer une alarme que lorsque la lampe L précédemment hors de fonctionnement a été remplacée par une nouvelle lampe L dont le type est inconnu. En effet, si la lampe L était précédemment en bon état de fonctionnement et qu'elle est désormais hors de fonctionnement, cela signifie qu'elle doit être remplacée avant que l'on ait besoin de connaître le type de la nouvelle lampe L.

Les moyens de gestion MG sont chargés d'intervenir (au moins) chaque fois que les moyens de comparaison MC génèrent une alarme relative à une lampe L d'une certaine famille. Dans cette situation, ils requièrent la fourniture du type de la nouvelle lampe L qui a remplacé l'ancienne. La requête est un message qui est destiné à être affiché sur l'écran d'affichage EA de la voiture V et/ou diffusée sous la forme d'un message audio par les haut-parleurs de la voiture V. Cet affichage et/ou cette diffusion est (sont) assuré(e)(s) par les moyens d'interface homme/machine MI.

Plus précisément, ces derniers (MI) sont chargés de requérir d'une personne (ici logée à l'intérieur de la voiture V) la fourniture du type d'un nouvel organe électrique L qui remplace le précédent. Par exemple, ils (MI) peuvent provoquer l'affichage d'un menu de sélection de type sur l'écran d'affichage EA. Dans ce cas, un premier sous-menu peut par exemple afficher les différentes familles d'organes électriques L afin que la personne sélectionne l'une d'entre elles, puis un second sous-menu peut afficher les différents types d'organes électriques L de la famille sélectionnée afin que la personne sélectionne l'un d'entre eux.

Dans une variante, il peut être demandé à la personne de saisir directement le type avec des touches (ou organes) de saisie qui font éventuellement partie des moyens d'interface homme/machine MI.

On notera que les moyens d'interface homme/machine MI peuvent être de tout type connu de l'homme de l'art. Ainsi, ils pourront être exclusivement de type logiciel, ou bien à la fois de type logiciel et matériel (circuits électroniques et/ou touches (ou organes) de saisie).

Une fois que le type a été fourni par une personne, les moyens d'interface homme/machine MI le communiquent aux moyens de gestion MG.

On notera que le type fourni peut être ensuite mémorisé dans une mémoire dédiée (non représentée) du dispositif D.

A réception du type de la lampe L remplacée, les moyens de gestion MG déterminent la valeur de chaque grandeur électrique qui va devoir être appliquée à cette nouvelle lampe L pour qu'elle produise un résultat choisi, compte tenu du résultat standard qui correspond à son type fourni au sein de la table de correspondance (stockée dans les moyens de stockage MS).

Le résultat choisi que doit produire la nouvelle lampe L est ici un flux lumineux d'une valeur prédéfinie.

On comprendra qu'une fois que les moyens de gestion MG connaissent (grâce à la table de correspondance) le résultat standard offert par une nouvelle lampe L, il est facile de déterminer la valeur de chaque grandeur électrique qui va devoir lui être appliquée pour qu'elle produise le résultat choisi escompté (permettant ainsi une continuité de résultat).

Par exemple, si la nouvelle lampe est de type haut rendement et qu'elle remplace une ancienne lampe de type standard, elle va produire un flux lumineux plus important que l'ancienne lampe si on lui applique la même valeur de grandeur physique que celle qui était appliquée à l'ancienne lampe. Par conséquent, si l'on veut que le flux lumineux produit par la nouvelle lampe demeure sensiblement identique à celui produit par l'ancienne lampe, il faut appliquer à la nouvelle lampe une valeur de grandeur physique inférieure à celle qui était appliquée à l'ancienne lampe.

De même, si la nouvelle lampe est de type économique et qu'elle remplace une ancienne lampe de type standard, elle va produire un flux lumineux moins important que l'ancienne lampe si on lui applique la même valeur de grandeur physique que celle qui était appliquée à l'ancienne lampe. Par conséquent, si l'on veut que le flux lumineux produit par la nouvelle lampe demeure sensiblement identique à celui produit par l'ancienne lampe, il faut appliquer à la nouvelle lampe une valeur de grandeur physique supérieure à celle qui était appliquée à l'ancienne lampe.

Une fois que les moyens de gestion MG ont déterminé la (ou les) nouvelle(s) valeur(s) de grandeur(s) électrique(s) à appliquer, ils la (les) communiquent au module qui contrôle l'alimentation électrique des organes comportant les lampes L ou au boîtier d'intelligence de la voiture V afin qu'il l'applique (les applique).

On notera que le dispositif D peut être également agencé de manière à permettre à une personne de fournir spontanément le type d'un nouvel organe électrique L d'une famille qu'elle vient d'installer dans le système V en remplacement d'un organe électrique qui fonctionnait correctement.

Pour ce faire, les moyens d'interface homme/machine MI peuvent par exemple disposer d'un menu (ou sous-menu) dédié à la fourniture spontanée et permettant à une personne de sélectionner une famille d'organes électriques, puis un type d'organe électrique de la famille sélectionnée. Dans une variante, le menu dédié peut demander à la personne de saisir directement le type avec des touches (ou organes) de saisie qui font éventuellement partie des moyens d'interface homme/machine MI.

Une fois que le type a été spontanément fourni par une personne, les moyens d'interface homme/machine MI le communiquent aux moyens de gestion MG. On notera que le type fourni spontanément peut être ensuite mémorisé dans une mémoire dédiée (non représentée) du dispositif D.

A réception du type de la lampe L remplacée, les moyens de gestion MG déterminent la valeur de la grandeur électrique qui va devoir être appliquée à cette nouvelle lampe L pour qu'elle produise un résultat choisi, compte tenu du résultat standard qui correspond à son type fourni au sein de la table de correspondance (stockée dans les moyens de stockage MS).

Le dispositif de gestion D selon l'invention, et notamment ses moyens (ou son module) de gestion MG et ses moyens (ou son module) de comparaison MC, ainsi qu'éventuellement ses moyens de stockage MS et/ou ses moyens d'interface homme/machine MI, peuvent être réalisés sous la forme de modules logiciels (ou informatiques). Mais, ils pourraient être également réalisés sous la forme de circuits électroniques ou d'une combinaison de circuits électroniques et de modules logiciels.

Il est important de noter que l'invention peut être également considérée sous l'angle d'un procédé de gestion, pouvant être notamment mis en oeuvre au moyen d'un dispositif de gestion D du type de celui présenté ci-avant. Les fonctionnalités offertes par la mise en oeuvre du procédé de gestion selon l'invention étant identiques à celles offertes par le dispositif de gestion D présenté ci-avant, seule la combinaison de fonctionnalités principales offerte par le procédé de gestion est présentée ci-après en référence à la figure 2.

Ce procédé de gestion consiste à effectuer trois étapes principales lors de chaque démarrage du système (ici une voiture) V.

Une première étape principale (i) débute lorsque la voiture V démarre (sous-étape 10 de la figure 2). Elle se poursuit par la lecture de l'état de fonctionnement en cours d'un organe électrique L et de l'état de fonctionnement préalablement mémorisé de cet organe électrique L (sous-étape 20 de la figure 2). Elle se poursuit ensuite par la comparaison des états de fonctionnement en cours et mémorisé qui ont été lus, de manière à déterminer si il existe une différence entre ces deux états lus (sous-étape 30 de la figure 2).

Si il n'existe pas de différence entre ces deux états lus, alors le procédé prend fin (sous-étape 40 de la figure 2). En revanche, si il existe une différence entre ces deux états lus, on génère une alarme (sous-étape 50 de la figure 2), ce qui met fin à la première étape principale (i).

Une deuxième étape principale (ii) est effectuée lorsqu'une alarme relative à un organe électrique L d'une famille (qui vient d'être remplacé) a été générée lors de la sous-étape 50. Elle consiste à requérir d'une personne (ici logée à l'intérieur de la voiture V) la fourniture du type du nouvel organe électrique L qui remplace le précédent (sous-étape 60 de la figure 2). Le type fourni peut être ensuite mémorisé (sous-étape 70 de la figure 2), ce qui met fin à la deuxième étape principale (ii).

Une troisième étape principale (iii) est effectuée lorsque la personne a effectivement fourni le type du nouvel organe électrique L qui remplace le précédent. Elle consiste à déterminer la valeur de chaque grandeur électrique qui doit être appliquée à ce nouvel organe électrique L pour qu'il produise un résultat choisi, compte tenu du résultat standard qui correspond à son type fourni au sein d'une table établissant une correspondance entre des types d'organes électriques L de famille(s) et des résultats standards propres (sous-étape 80 de la figure 2). Une fois cette détermination effectuée, le procédé prend fin. On peut alors appliquer au nouvel organe électrique L la valeur de chaque grandeur électrique qui a été déterminée pour lui.

L'invention ne se limite pas aux modes de réalisation de dispositif de gestion et de procédé de gestion décrits ci-avant, seulement à titre d'exemple, mais elle englobe toutes les variantes que pourra envisager l'homme de l'art dans le cadre des revendications ci-après.

## Revendications

1. Dispositif (D) de gestion du fonctionnement d'organe(s) électrique(s) (L) faisant partie d'un système (V), interchangeable(s), produisant un résultat variable en fonction de la valeur d'au moins une grandeur électrique qui lui (leur) est appliquée, et appartenant à au moins une famille subdivisée en au moins deux types différents correspondant à des résultats standards propres, **caractérisé en ce qu'**il comprend i) des moyens de stockage (MS) propres à stocker une table établissant une correspondance entre des types d'organes électriques (L) de famille(s) et des résultats standards propres, ii) des moyens de comparaison (MC) agencés pour générer une alarme lorsque des états de fonctionnement en cours et mémorisé d'un organe électrique (L) diffèrent, iii) des moyens d'interface homme/machine (MI) agencés pour permettre à une personne de fournir le type d'un organe électrique (L) d'une famille, et iv) des moyens de gestion (MG) agencés, en cas de génération d'une alarme relative à un organe électrique (L) d'une famille, pour requérir la fourniture du type de cet organe électrique (L), puis pour déterminer la valeur de chaque grandeur électrique devant être appliquée à cet organe électrique (L) pour qu'il produise un résultat choisi, compte tenu du résultat standard qui correspond à son type fourni au sein de ladite table.

2. Dispositif selon la revendication 1, **caractérisé en ce que** lesdits moyens de gestion (MG) sont agencés, lorsqu'une personne fournit spontanément, via lesdits moyens d'interface homme/machine, le type d'un organe électrique (L) d'une famille qui vient d'être remplacé dans ledit système (V), pour déterminer la valeur de chaque grandeur électrique devant être appliquée à cet organe électrique (L) pour qu'il produise un résultat choisi compte tenu du résultat standard qui correspond à son type fourni au sein de ladite table.

3. Procédé de gestion du fonctionnement d'organe(s) électrique(s) (L) faisant partie d'un système (V), interchangeable(s), produisant un résultat variable en fonction de la valeur d'au moins une grandeur électrique qui lui (leur) est appliquée, et appartenant à au moins une famille subdivisée en au moins deux types différents correspondant à des résultats standards propres, **caractérisé en ce qu'**il consiste à effectuer les étapes suivantes lors de chaque démarrage dudit système (V) :
i) comparer l'état de fonctionnement en cours d'un organe électrique (L) à un état de fonctionnement mémorisé de cet organe électrique (L), de manière à générer une alarme lorsque ces états de fonctionnement diffèrent,
ii) en cas de génération d'une alarme relative à un organe électrique (L) d'une famille, requérir la fourniture du type de cet organe électrique (L), par une personne, au travers de moyens d'interface homme/machine (MI), et
iii) déterminer la valeur de chaque grandeur électrique devant être appliquée audit organe électrique (L) pour qu'il produise un résultat choisi, compte tenu du résultat standard qui correspond à son type fourni au sein d'une table établissant une correspondance entre des types d'organes électriques (L) de famille(s) et des résultats standards propres.

4. Procédé selon la revendication 3, **caractérisé en ce qu'**en cas de fourniture spontanée du type d'un organe électrique (L) d'une famille qui vient d'être remplacé dans ledit système (V), on détermine la valeur de chaque grandeur électrique devant être appliquée à cet organe électrique (L) pour qu'il produise un résultat choisi, compte tenu du résultat standard qui correspond à son type fourni au sein de ladite table.

5. Utilisation du dispositif de gestion (D) selon l'une des revendications 1 et 2 et du procédé de gestion selon l'une des revendications 3 et 4 dans le cas d'organes électriques (L) choisis dans un groupe comprenant des lampes, des ampoules et des diodes propres à produire un résultat de type flux lumineux.

6. Utilisation selon la revendication 5 dans le cas d'un système (V) de type véhicule.
